Europäisches Patentamt

European Patent Office

Office européen des brevets

(11) Numéro de publication : **0 387 144 B1**

(12) **FASCICULE DE BREVET EUROPEEN**

(19)

(45) Date de publication du fascicule du brevet :
**02.03.94 Bulletin 94/09**

(51) Int. Cl.⁵ : **C23C 14/50, C23C 14/24**

(21) Numéro de dépôt : **90400610.3**

(22) Date de dépôt : **06.03.90**

(54) **Dispositif pour recouvrir une surface plane d'une couche d'épaisseur uniforme.**

(30) Priorité : **08.03.89 FR 8903028**

(43) Date de publication de la demande :
**12.09.90 Bulletin 90/37**

(45) Mention de la délivrance du brevet :
**02.03.94 Bulletin 94/09**

(84) Etats contractants désignés :
**CH DE GB IT LI**

(56) Documents cités :
**CH-A- 483 497**
**US-A- 3 746 571**
**US-A- 3 858 547**

(73) Titulaire : **COMMISSARIAT A L'ENERGIE ATOMIQUE**
**31/33, rue de la Fédération**
**F-75015 Paris Cédex 15 (FR)**
Titulaire : **ETAT-FRANCAIS représenté par le DELEGUE GENERAL POUR L'ARMEMENT**
**F-00450 Armées (FR)**

(72) Inventeur : **Gailliard, Jean-Pierre**
**74 rue des Eaux Claires**
**F-38100 Grenoble (FR)**
Inventeur : **Perrin, Aimé**
**Le Crêt de Chaume**
**F-38330 Saint Ismier (FR)**

(74) Mandataire : **Mongrédien, André et al**
**c/o BREVATOME 25, rue de Ponthieu**
**F-75008 Paris (FR)**

**Description**

La présente invention se rapporte à un dispositif pour recouvrir une surface plane d'une couche d'épaisseur uniforme formée de particules émises par une source.

Les techniques de dépôts superficiels de matériaux sur des substrats au moyen de l'évaporation ou de la vaporisation d'une source qui émet des particules suivant un faisceau divergent en direction du substrat sont bien connues. Diverses méthodes pour uniformiser l'épaisseur des dépôts ont été proposées. Par exemple, on peut placer les substrats sur la face interne d'un appui en forme de dôme dont le centre de courbure est proche de la source. Cette solution n'est toutefois envisageable que pour le dépôt simultané sur un grand nombre de petits substrats et non pour des substrats plans de grande taille.

La technique la plus proche de l'invention consiste à faire tourner le substrat autour d'un axe parallèle à la direction médiane d'émission du faisceau, l'axe pouvant être confondu ou non avec cette direction. Un bras radial porte à son extrémite le substrat dont les portions des normales sortant du substrat par la surface à recouvrir sont soit parallèles à l'axe soit dirigées vers celui-ci. La surface à revêtir est dans ce cas tournée vers l'intérieur du dispositif. Il est alors avantageux de faire tourner le substrat sur lui-même simultanément à une vitesse de rotation normalement nettement supérieure à la vitesse de rotation de l'axe. On réalise ainsi ce qu'on appelle un mouvement planétaire du substrat.

Il n'est cependant pas possible d'obtenir des dépôts présentant des variations d'épaisseur de moins de 2 % sur des substrats de grandes dimensions (300 mm de diamètre par exemple). Le but essentiel de l'invention est d'obtenir des résultats bien meilleurs.

La solution retenue consiste à incliner le substrat par rapport à l'axe de rotation pour orienter sa face recevant le dépôt vers l'extérieur. Quoique cette disposition aille à l'encontre de techniques de l'art antérieur décrites auparavant où on s'efforçait d'orienter le substrat en direction de la source, elle améliore grandement l'uniformité des dépôts, ce qui peut être considéré comme surprenant.

L'uniformité obtenue reste d'ailleurs excellente pour toutes les caractéristiques d'émissivité de la source : des simulations sur ordinateur ont été effectuées en faisant varier les coefficients du développement en série de puissances de cosinus $\theta$, série par laquelle on peut caractériser l'intensité du rayonnement pour toute direction d'émission en fonction de l'angle $\theta$ qu'il fait avec la direction d'émission médiane du faisceau. Une grande stabilité des résultats a été obtenue.

L'invention concerne donc un dispositif pour recouvrir une surface plane d'une couche d'épaisseur uniforme de particules émises par une source, comprenant un axe tournant autour de lui-même et muni d'un bras radial, le bras radial étant muni à son extrémité opposée à l'axe de moyens de support tournant de la surface plane imprimant à la surface plane un mouvement de rotation dans son plan, caractérisé en ce que les moyens de support tournant sont constitués de sorte que la surface plane est orientée vers l'extérieur du dispositif et les portions des normales au substrat sortant par la surface plane font un angle $\phi$ supérieur à dix degrés avec une portion de l'axe dirigée vers la source et sont dirigées en s'éloignant de l'axe à partir de la surface plane.

On va maintenant décrire pour plus de clarté l'invention à l'aide des figures suivantes annexées à titre illustratif et non limitatif :

- la figure 1 représente schématiquement un dispositif de mise en oeuvre de l'invention ; et
- la figure 2 représente les résultats obtenus.

Le substrat 1 plan à recouvrir est dans ce cas particulier un disque de rayon r. Il est fixé sur un porte-substrat 8 situé à une extrémité d'un bras radial 2 de longueur L. Le bras 2 est assujetti à son autre extrémité à un axe vertical 3. La normale à la surface 4 à revêtir du substrat 1 fait un angle $\phi$ avec la direction parallèle à l'axe 3. D'après l'invention, la face 4 du substrat 1 qu'il faut recouvrir est orientée vers l'extérieur du dispositif.

Des dispositifs moteurs non représentés assurent la rotation de l'axe 3 et d'un autre axe 7 porté par le bras 2 et auquel le porte-substrat 8 est attaché. La seconde vitesse de rotation est nettement supérieure à la première.

Tout en tournant sur lui-même, le substrat 1 suit donc une trajectoire circulaire.

Le centre du substrat 1 est espacé du plan horizontal contenant la source 5 d'une hauteur h et celle-ci présente un axe d'émission médiane 6 (axe du cône d'émission) parallèle à l'axe 3 dont il est excentré d'une distance d. Les particules émises par la source 5 se déplacent suivant des trajectoires rayonnantes que l'on peut définir par l'angle $\theta$ qu'elles font avec l'axe d'émission médiane 6.

L'indicatrice d'émission de la source 5 en fonction de l'angle $\theta$ peut être définie par un développement en série de puissances de cos $\theta$. La figure 2 représente, sous forme d'abaque à deux entrées d et $\phi$, les pourcentages maximaux de défauts d'homogénéité d'épaisseur obtenus sur le substrat 1 quels que soient les coefficients du développement en série de puissance de cos $\theta$ limité à la puissance 7. On avait h = 60 cm, L = 23 cm et r = 15 cm. Il existe une zone préférentielle où l'homogénéité des épaisseurs déposées est particulièrement bonne et qui correspond, pour cet exemple, à de faibles distances d, inférieures à 20 cm environ, et à des angles d'inclinaison φ du substrat 1 assez prononcés, de plus de 10° environ. L'endroit le plus intéressant de cette zone correspond à une distance d comprise entre 9 cm et 12,5 cm environ et à un angle φ compris entre 21° et 23°. Les disparités d'uniformité y sont comprises entre 0,2 % et 0,5 %. Ces résultats montrent que l'invention permet de réaliser des dépôts d'uniformité satisfaisante même si la forme de l'indicatrice d'émission de la source varie avec le temps, ce qui est notamment le cas des canons à électrons où la charge se creuse relativement rapidement.

D'autres essais ont été menés : ils font apparaître la persistance d'une plage de bonne uniformité d'épaisseur de recouvrement du substrat 1 pour des angles φ proches de ceux mentionnés, encore orientés vers l'extérieur et généralement compris entre 18° et 25°. On peut considérer qu'avec des configurations plausibles l'angle φ optimal sera compris entre 15° et 30°.

Le tableau I indique, en fonction de r, h et L, les meilleures valeurs des paramètres d et φ. Les longueurs sont toutes données en centimètres.

### TABLEAU I

| r | h | L | d | φ |
|---|---|---|---|---|
| 15 | 60 | 30 | 18 | 18 |
| 15 | 60 | 26 | 14 ou 15 | 20 |
| 15 | 60 | 23 | 10 | 22 |
| 15 | 60 | 20 | 4 | 25 |
| 15 | 50 | 20 | 10 | 22 |
| 15 | 40 | 20 | 12 | 20 |

L'invention peut être utilisée avec une seule source située dans le prolongement de l'axe 3 (d = 0) ; cette configuration permet d'utiliser une source dite "étendue" de rayon supérieur à 1 cm. Ainsi, de bonnes uniformités de recouvrement ont été obtenues avec par exemple h = 60 cm, L = 20 cm, r = 15 cm et φ = 24°, la source ayant un rayon de 6 cm. Le bras 2 peut être remplacé par une roue ou une structure analogue pour recouvrir simultanément plusieurs substrats.

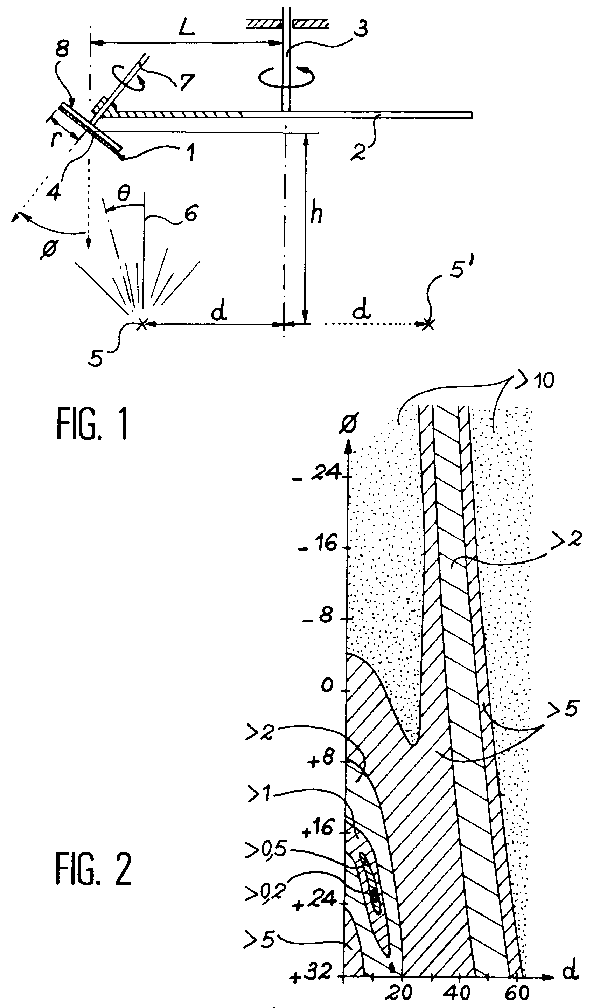

Pour augmenter la vitesse de dépôt, on peut utiliser une source annulaire de rayon d ou une pluralité de sources, dont une 5' est représentée figure 1, disposées sur un cercle de rayon d.

Une application intéressante du dispositif concerne la fabrication de filtres optiques éventuellement de grand diamètre. On remarquera que les dimensions du substrat 1 peuvent être assez importantes par rapport à son éloignement de la source 5, comme dans l'exemple décrit, ce qui fait qu'une partie non négligeable du rayonnement est interceptée.

## Revendications

1. Dispositif pour recouvrir une surface plane (4) d'une couche d'épaisseur uniforme de particules émises par une source (5), comprenant un axe (3) tournant autour de lui-même et muni d'un bras radial (2), le bras radial étant muni à son extrémité opposée à l'axe de moyens de support tournant (8) de la surface plane (4) imprimant à la surface plane (4) un mouvement de rotation dans son plan, caractérisé en ce que les moyens de support tournant (8) sont constitués de sorte que la surface plane est orientée vers l'extérieur du dispositif et les portions de normales au substrat sortant par la surface plane (4) font un angle (φ) supérieur à dix degrés avec une portion de l'axe (3) dirigée vers la source (5) et sont dirigées en s'éloignant de l'axe (3) à partir de la surface plane.

2. Dispositif pour recouvrir une surface plane (4) selon la revendication 1, caractérisé en ce que l'angle des portions de normales et de l'axe est compris entre quinze et trente degrés.

3. Dispositif pour recouvrir une surface plane (4) selon la revendication 2, caractérisé en ce que l'angle des portions de normales et de l'axe est compris entre dix-huit et vingt-cinq degrés.

4. Dispositif pour recouvrir une surface plane selon l'une quelconque des revendications 1 à 3, caractérisé en ce que la source est ponctuelle et excentrée d'une distance (d) de l'axe (3).

5. Dispositif pour recouvrir une surface plane selon l'une quelconque des revendications 1 à 3 caractérisé en ce que la source (5) est centrée sur l'axe (3) et a un rayon supérieur à un centimètre.

6. Dispositif pour recouvrir une surface plane selon l'une quelconque des revendications 1 à 3, caractérisé en ce que la source est composée de plusieurs sources élémentaires (5, 5') disposées sur un cercle.


**Patentansprüche**

1. Vorrichtung zum Überziehen einer ebenen Fläche (4) mit einer Schicht von einheitlicher Dicke aus Partikeln, die ausgestrahlt werden von einer Quelle (5), umfassend eine Achse (3), die sich um sich selbst dreht, und ausgestattet mit einem Radialarm (2), wobei der Radialarm an seinem der Achse entgegengesetzten Ende versehen ist mit sich drehenden Aufnahmeeinrichtungen (8) der ebenen Fläche (4), die Fläche (4) in eine Rotationsbewegung in ihrer Ebene versetzend,
dadurch **gekennzeichnet,**
daß die sich drehenden Aufnahmeeinrichtungen (8) so ausgebildet sind, daß die ebene Fläche gegen die Außenseite der Vorrichtung gerichtet ist, und die Teile der zum Substrat Senkrechten, die aus der ebenen Fläche (4) austreten, einen Winkel ($\phi$) größer als 10° bilden mit einem Teil der Achse (3), der gegen die Quelle (5) gerichtet ist, und sich ab der ebenen Fläche von der Achse (3) entfernen.

2. Vorrichtung zum Überziehen einer ebenen Fläche (4) nach Anspruch 1, dadurch gekennzeichnet, daß der Winkel der Teile der Senkrechten und der Achse enthalten ist zwischen fünfzehn und dreißig Grad.

3. Vorrichtung zum Überziehen einer ebenen Fläche (4) nach Anspruch 2, dadurch gekennzeichnet, daß der Winkel der Teile der Senkrechten und der Achse enthalten ist zwischen achtzehn und fünfundzwanzig Grad.

4. Vorrichtung zum Überziehen einer ebenen Fläche nach einem der Ansprüche 1 bis 3, dadurch gekennzeichnet, daß die Quelle punktförmig ist und exzentrisch zu der Achse (3) mit einem Abstand (d).

5. Vorrichtung zum Überziehen einer ebenen Fläche nach einem der Ansprüche 1 bis 3, dadurch gekennzeichnet, daß die Quelle (5) auf der Achse (3) zentriert ist und einen Durchmesser größer als ein Zentimeter aufweist.

6. Vorrichtung zum Überziehen einer ebenen Fläche nach einem der Ansprüche 1 bis 3, dadurch gekennzeichnet, daß die Quelle zusammengesetzt ist aus mehreren Elementarquellen (5, 5'), die auf einem Kreis angeordnet sind.


**Claims**

1. Device for covering a planar surface (4) with a layer of uniform thickness of particles emitted by a source (5), incorporating an axis or shaft (3) rotating about itself and provided with a radial arm (2), the radial arm being provided at its end opposite to the shaft with means (8) for the rotary supporting of the planar surface (4) imparting to the latter a rotary movement in its plane, characterized in that the rotary support means (8) are constructed in such a way that the planar surface is oriented towards the outside of the device and the portions of the lines perpendicular to the substrate passing out through the planar surface (4) form an angle ($\theta$) exceeding 10° with a portion of the shaft (3) directed towards the source (5) and which are directed on moving away from the shaft (3) as from the planar surface.

2. Device for covering a planar surface (4) according to claim 1, characterized in that the angles of the portions of the perpendicular lines and the axis is between 15 and 30°.

3.  Device for covering a planar surface (4) according to claim 2, characterized in that the angle of the portions of the perpendicular lines and the axis is between 18 and 25°.

4.  Device for covering a planar surface according to any one of the claims 1 to 3, characterized in that the source is punctiform and off-centred by a distance (d) from the shaft (3).

5.  Device for covering a planar surface according to any one of the claims 1 to 3, characterized in that the source (5) is centred on the shaft (3) and has a radius exceeding 1 centimetre.

6.  Device for covering a planar surface according to any one of the claims 1 to 3, characterized in that the source is constituted by several elementary sources (5, 5') arranged on a circle.

FIG. 1

FIG. 2